# EUROPÄISCHE PATENTSCHRIFT

(11) **EP 1 713 110 B1**
(45) Veröffentlichungstag und Bekanntmachung des Hinweises auf die Patenterteilung: **09.03.2016**
(21) Anmeldenummer: 05007805.4
(22) Anmeldetag: 08.04.2005
(51) Int. Cl.: C23C 14/56, H01J 37/32

(54) **Anlage zum Beschichten eines Substrats und Modul**
Device for coating a substrate and module
Dispositif pour appliquer un revêtement sur un substrat et module

(43) Veröffentlichungstag der Anmeldung: 18.10.2006
(73) Patentinhaber: Applied Materials GmbH & Co. KG, 63755 Alzenau (DE)
(72) Erfinder: Buchberger, Hans, 61476 Kronberg (DE); Geiss, Andreas, 63452 Hanau (DE); Krempel-Hesse, Jörg Dr., 63683 Eckartsborn (DE); Haas, Dieter, 63486 Bruchköbel (DE)
(74) Vertreter: Bockhorni & Kollegen

(56) Entgegenhaltungen:
- DE-A1- 10 237 311
- US-A- 4 026 787
- US-A- 4 693 803
- PATENT ABSTRACTS OF JAPAN Bd. 2000, Nr. 26, 1. Juli 2002 (2002-07-01) & JP 2001 253536 A (HIRATA CORP), 18. September 2001 (2001-09-18)

## Beschreibung

Die Erfindung betrifft eine Anlage zum Beschichten eines Substrats, umfassend eine Beschichtungskammer, und ein Modul für eine Anlage zum Beschichten eines Substrats.

Bei herkömmlichen Beschichtungsanlagen für die Beschichtung zur Herstellung von Flachbildschirmen, Farbfiltern, Displays und dergleichen werden die Substrate mittels üblicher Spanneinrichtungen auf einer Aluminiumplatte aufgenommen und durch eine Beschichtungsanlage mit mehreren Kammern geführt.

Zu Wartungs- und Reinigungszwecken wird ein Wandstück der Kammer abgenommen bzw. abmontiert. Anschließend kann der Innenraum der Kammer gereinigt und ein Targetwechsel vorgenommen werden. Währenddessen steht die Anlage still. Die Ausfallzeiten sind relativ lang, da der Zugriff zum Innenraum der Kammer beschränkt und zudem unkomfortabel ist.

Zwischen den einzelnen Beschichtungskammern sind Pumpenkompartments angeordnet, über die die Klammern evakuiert werden. Auf Grund dieser Bauweise erstrecken sich herkömmliche Anlagen über eine relativ große Länge.

US 4693 803 A offenbart eine Beschichtungsanlage mit zwei gegeneinander verfahrbaren Trägern mit Prozeßwerkzeugen, woduch Wartungsarbeiten ermöglicht werden.

Ausgehend davon ist es eine Aufgabe der vorliegenden Erfindung, eine Beschichtungsanlage bzw. ein Modul für eine Beschichtungsanlage bereitzustellen, welches die Wartungsarbeiten an Verschleißteilen erleichtert und die Ausfallzeiten der Anlage verringert.

Diese Aufgabe wird gelöst durch eine Beschichtungsanlage nach Anspruch 1 und ein Modul für eine Beschichtungsanlage nach Anspruch 8. Bevorzugte Ausführungsformen werden in den Ansprüchen 2 bis 7 und 9 bis 16 definiert.

Eine erfindungsgemäße Anlage zum Beschichten eines Substrats umfasst eine Beschichtungskammer, die modular aufgebaut ist, wobei ein Modul einen Kammerabschnitt, einen ersten Träger, der entfernbar im bzw. am Kammerabschnitt angeordnet ist, und einen zweiten Träger, der entfernbar am ersten Träger angeordnet ist, aufweist. Die Anlage wird beispielsweise für die Beschichtung eines transparenten Substrats, insbesondere zur Herstellung von Bildschirmen, eingesetzt.

Bedarfsweise können in einer Beschichtungsanlage beliebig viele Module in Reihe angeordnet werden. In den Modulen können gleiche oder unterschiedliche Prozesse ablaufen. Durch den modularen Aufbau können die Anlagen flexibel zusammengestellt bzw. aufgebaut werden. Es kann im Rahmen der Erfindung jedoch auch lediglich ein einziges Modul als Teil einer Beschichtungskammer bzw. als Beschichtungskammer eingesetzt werden.

Die Träger können vom gefluteten Kammerabschnitt weggezogen bzw. weggefahren werden. Außerdem können sie voneinander entfernt werden. Der erste Träger ist im Wesentlichen zwischen dem Kammerabschnitt und dem zweiten Träger angeordnet. Auf diese Weise entsteht ein ,Sandwich"-artiger Aufbau.

Für Wartungszwecke wird zunächst der äußere Träger vom ersten Träger und von der Beschichtungskammer entfernt. Alternativ dazu können beide Träger gemeinsam vom Kammerabschnitt weggefahren werden. Anschließend wird der erste Träger vom Kammerabschnitt wegbewegt bzw. die Träger werden getrennt und einer der Träger vom anderen wegbewegt. Auf diese Weise entstehen für Personal zugängliche Wartungsbereiche zwischen dem Kammerabschnitt und dem ersten Träger und/oder zwischen dem ersten und dem zweiten Träger.

Da die Träger vom Kammerabschnitt entfernbar sind, können zwischen den Modulkomponenten für Personen zugängliche Bereiche geschaffen werden. Dadurch wird der Zugriff auf die Baukomponenten in den einzelnen Modulkomponenten (Kammerabschnitt, erster Träger, zweiter Träger) erleichtert. Insbesondere kann zugleich auf die Beschichtungskammer und die Kathoden zugegriffen werden, z.B. zur Wartung. Somit können beispielsweise zwei Teams gleichzeitig die Anlage reinigen und warten, wobei ein Team Zugang zum freien Raum zwischen dem ersten Träger und dem Kammerabschnitt, und das zweite Team Zugang zwischen dem zweiten Träger und dem ersten Träger erhält. Das erste Team säubert die Beschichtungskammer, insbesondere die darin befindlichen Blenden und dgl., während das zweite Team die Kathoden wartet. Auf diese Weise können Ausfallzeigen auf Grund von Wartungs- und Reinigungsarbeiten erheblich verringert werden.

Der erste Träger ist seitlich entfernbar am Kammerabschnitt und der zweite Träger seitlich entfernbar am ersten Träger angeordnet. Der Begriff seitlich bezieht sich auf die Transportrichtung der Substrate und entsprechend die Längsachse der gesamten Anlage:
Der zweite Träger ist zum Verschließen einer seitlichen Öffnung des Kammerabschnitts ausgebildet.

Am ersten Träger ist wenigstens ein Prozesswerkzeug angeordnet.

Als Prozesswerkzeuge kommen beispielsweise Kathoden für einen Sputterprozess, im Allgemeinen jedoch auch Werkzeuge für andere Prozesse wie Verdampfung in Frage. Am ersten Träger können neben den Prozesswerkzeugen Kühlungen für die Kathoden und Blenden, Medienanschlüsse, die Kathodenumgebung (Blendenabschirmungen), Trennwände zur Trennung einzelner Kathoden, der Antrieb rotierbarer Kathoden, usw. angeordnet sein. Die Versorgung mit Elektrizität, Kühlwasser und Prozessgas kann über entsprechende Anschlüsse am Träger erfolgen. Ein Kerngedanke der Erfindung ist eine möglichst durchdachte Zuordnung der Komponenten zu den Modulkomponenten, so dass die Komponenten gut zugänglich, einfach zu warten und unkompliziert mit Energie oder Prozessgas zu versorgen sind.

Das Prozesswerkzeug weist bevorzugt wenigstens eine Sputterkathode auf.

Das Prozesswerkzeug weist insbesondere wenigstens eine Flachkathode und/oder wenigstens eine rotierbare Kathode auf.

Es können mehrere Prozesswerkzeuge benachbart am ersten Träger angeordnet sein.

Die Prozesswerkzeuge können in einen gemeinsamen Prozessraum in der Beschichtungskammer angeordnet sein. Ein Vorteil dieser Ausführungsform besteht in der kompakten Bauweise. Es ist möglich, eine Vielzahl von Kathoden (z.B. ITO) in dem ersten Träger anzuordnen.

Der erste Träger kann jedoch auch so ausgebildet sein, dass wenigstens zwei Prozesswerkzeuge oder wenigstens zwei Gruppen von Prozesswerkzeugen in der Beschichtungskammer durch ein am ersten Träger angeordnetes Zwischenelement voneinander getrennt sind. Bei voneinander getrennten Kathoden kann jeder Kathode eine eigene Pumpe oder eine Gruppe von Pumpen, die hinter der Kathode am Deckel angeordnet ist, zugeordnet werden. Die Zuordnung einer eigenen Pumpe oder einer Gruppe von Pumpen zu jeder Kathode ist besonders günstig, da so eine individuelle Einstellung der Gasflüsse an jeder Kathode ermöglicht wird. Während in einer gemeinsamen Prozesskammer in der Regel gleiche Kathoden, etwa ITO-Kathoden, zum Einsatz kommen, können in der vorliegenden Ausführungsform auch unterschiedliche Kathoden verwendet werden, da in der Umgebung der getrennten Kathoden eine spezielle Atmosphäre erzeugt werden kann.

Die Anlage weist bevorzugt eine Pumpeinrichtung zur Erzeugung eines Vakuums in der Beschichtungskammer mit Pumpen auf, wobei wenigstens eine der Pumpen am zweiten Träger angeordnet ist. Eine Zuordnung der Beschichtungskomponenten auf die drei Modulteile wird unter verschiedenen Gesichtspunkten, wie Versorgung oder Zugriff für Wartungsarbeiten, durchgeführt. Durch die Anordnung der Pumpen am zweiten Träger (d.h. am Deckel) kann die Baulänge der Gesamtanlage reduziert werden, da keine Pumpenkompartments benötigt werden, die in Reihe mit den Beschichtungskammern geschaltet werden. Die Pumpen sind nun hinter den Kathoden angeordnet.

Der erste Träger und/oder der zweite Träger sind als aus dem Kammerabschnitt seitlich herausziehbare Wagen oder Schlitten bzw. vom Kammerabschnitt seitlich wegfahrbare Wagen oder Schlitten ausgebildet.

Bevorzugt sind Mittel zur Führung des ersten und/oder des zweiten Trägers beim Herausziehen aus dem Kammerabschnitt bzw. beim Wegfahren vom Kammerabschnitt und/oder beim Hineinschieben in den Kammerabschnitt bzw. beim Heranfahren zum Kammerabschnitt vorgesehen.

Die Mittel zur Führung der Träger sind bevorzugt so ausgebildet, dass der aus dem Kammerabschnitt herausgezogene erste Träger so weit vom Kammerabschnitt entfernt werden kann, dass zwischen dem ersten Träger und dem Kammerabschnitt ein für Personen zugänglicher Bereich entsteht.

Die Mittel zur Führung der Träger können so ausgebildet sein, dass der vom ersten Träger weggefahrene zweite Träger so weit vom ersten Träger entfernt werden kann, dass zwischen dem ersten Träger und dem zweiten Träger ein für Personen zugänglicher Bereich entsteht.

Der Kammerabschnitt kann eine im Wesentlichen vertikal ausgerichtete Durchführungsöffnung zur Durchführung des zu beschichtenden Substrats durch den Kammerabschnitt aufweisen. Prinzipiell soll die Erfindung jedoch nicht auf eine vertikale Ausrichtung der durchgeführten Substrate beschränkt sein, da das Erfindungsprinzip auch auf horizontale Anordnungen anwendbar ist.

Die Prozesswerkzeuge sind insbesondere am ersten Träger im Wesentlichen vertikal angeordnet. Aus den oben genannten Gründen ist jedoch auch eine andere, an die Erfordernisse angepasste Ausrichtung der Kathoden denkbar.

Die Anlage weist insbesondere wenigstens zwei symmetrisch bezüglich der Längsachse der Anlage angeordnete Module auf. Diese Ausführungsform ist bei Anlagen mit Wendestation zur Reduktion der Baulänge der Gesamtanlage vorteilhaft.

Ein erfindungsgemäßes Modul für eine Anlage zum Beschichten eines Substrats umfasst wenigstens einen Kammerabschnitt, einen ersten Träger, der entfernbar im bzw. am Kammerabschnitt angeordnet ist, und einen zweiten Träger, der entfernbar am ersten Träger angeordnet ist.

Insbesondere weist das Modul Merkmale auf wie oben bereits beschrieben.

Weitere Merkmale und Vorteile der Erfindung ergeben sich aus der nachfolgenden Beschreibung spezieller Ausführungsbeispiele.

Es zeigen:
- Fig. 1: eine perspektivische Ansicht eines erfindungsgemäßen Moduls für eine Beschichtungsanlage;
- Fig. 2: eine schematische Ansicht einer Beschichtungsanlage von oben;
- Fig. 3: eine Ansicht zweier Module von oben; und
- Fig. 4: eine perspektivische Ansicht eines erfindungsgemäßen Moduls.

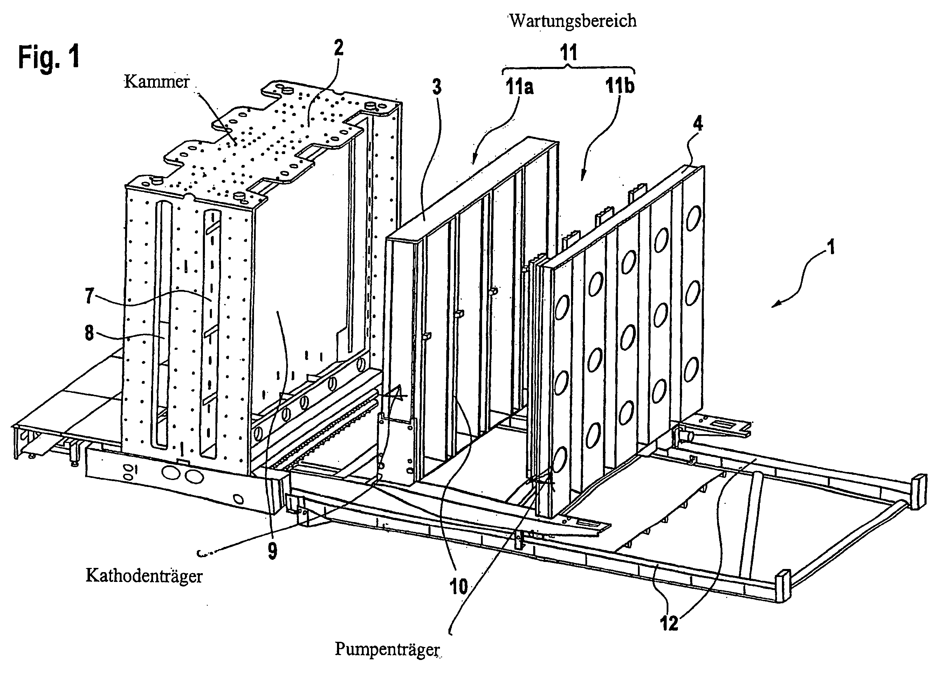

Die Fig. 1 zeigt eine perspektivische Darstellung eines erfindungsgemäßen Moduls 1 für eine Beschichtungsanlage. Das Modul 1 besteht aus einer Kammer bzw. einem Kammerabschnitt 2, einem Zwischenträger 3, in dem Kathoden angeordnet sind, und einem Deckel 4.

Der Kammerabschnitt 2 weist beidseitig eine Öffnung 7 zur vertikalen Durchführung der Substrate durch den Kammerabschnitt 2 auf.

Die Beschichtungskammer ist in diesem Beispiel symmetrisch aufgebaut, da das Modul für den Einsatz in einer Beschichtungsanlage mit Wendestation vorgesehen ist. Dem entsprechend weist der Kammerabschnitt 2 symmetrisch zu den Öffnungen 7 Öffnungen 8 auf. Die Pfeile geben die Transportrichtung der Substrate an. Eine Zwischenwand 9 trennt die im Wesentlichen symmetrisch ausgebildeten Kammersegmente des Kammerabschnitts 2.

In dem Kammerabschnitt 2 sind in der Regel die Antriebe für das Substrat sowie die Sensorik untergebracht. Außerdem ist eine Abschirmung und/oder Heizung vor der Kammerrück- bzw. Zwischenwand 9 vorgesehen.

Der Zwischenträger 3 ist im vorliegenden Beispiel als Schlitten bewegbar gegenüber dem Kammerabschnitt 2 ausgebildet. Der Träger 3 ist wenigstens zwischen einer Betriebsposition, in der er in den Kammerabschnitt 2 hinein- bzw. an den Kammerabschnitt 2 herangefahren wird, und einer Wartungsposition, wie in der Fig. 1 dargestellt, verfahrbar. Durch das seitliche Wegfahren des Trägers 3 von der Kammer 2 wird ein Wartungsdurchgang 11a freigegeben, der für Personal zugänglich ist, so dass Wartungsarbeiten im Kammerabschnitt 2 und an den Komponenten, die im Träger 3 angeordnet sind (z.B. Targetwechsel), bequem und unkompliziert durchgeführt werden können. Vom Wartungsbereich 11a ist ein Zugriff sowohl zum Innenraum des Kammerabschnitts 2 als auch zum Träger 3 möglich.

Der Zwischenträger 3 trägt im Wesentlichen die Kathoden (in Fig. 1 nicht dargestellt). Im vorliegenden Beispiel sind die Kathoden durch Zwischenwände 10 im Träger 3 voneinander getrennt. Am Träger sind neben den Kathoden die Blenden, die Kühlung für die Kathoden und die Blenden, und Medienanschlüsse vorgesehen. Die Medienanschlüsse können beispielsweise unten am Träger 3 angeordnet sein. Die Kathodenumgebung (Blendenabschirmungen) umfasst eventuell weitere Trennwände 10 zur Trennung einzelner Kathoden voneinander sowie einen Antrieb für den Fall, dass rotierbare Kathoden eingesetzt werden. Die Versorgungsanschlüsse für Elektrizität können beispielsweise oben am Träger 3 angeordnet sein, so dass für die Durchführung von Wartungsarbeiten kein Abtrennen der Versorgungsleitungen erforderlich ist.

Der Deckel 4 ist ebenfalls als Schlitten ausgebildet und unabhängig von dem ersten Träger 3 gegenüber diesem bewegbar. Dies bedeutet, dass der Träger 3 und der Deckel 4 voneinander wegbewegt werden können, wodurch ein zusätzlicher Wartungsgang 11b freigegeben wird. In der Wartungsposition entsteht ein für Personal zugänglicher Bereich 11b, von dem aus die am Träger 3 ;und am Deckel 4 angeordneten Komponenten zugänglich sind.

Der Deckel 4 trägt im Wesentlichen die Turbomolekularpumpen (in Fig. 1 nicht dargestellt) des Vakuumsystems und ist vom Zwischenträger 3 separierbar. Der Träger 3 und der Deckel 4 können im Wesentlichen unabhängig voneinander auf Schienen 12 geführt werden.

In der Betriebsposition sind sowohl der Träger 3 als auch der Deckel 4 an den Kammerabschnitt 2 herangefahren. Der Deckel 4 verschließt die Öffnung in der Seitenwand des Kammerabschnitts 2 bzw. Öffnungen im Träger 3. Aus der Figur wird der "Sandwich"-artige Aufbau des Moduls 1 deutlich.

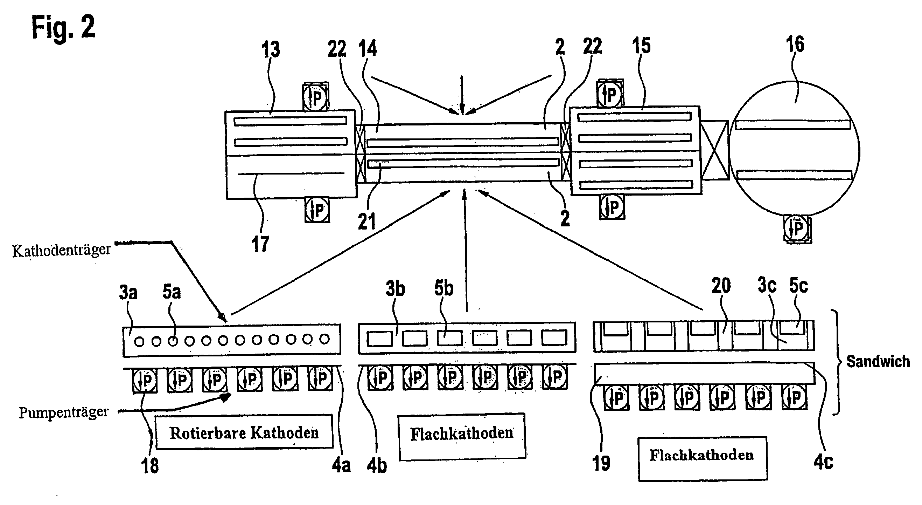

Die Fig. 2 zeigt schematisch den Aufbau einer beliebigen Beschichtungsanlage von oben. Die Anlage weist eine der Beschichtungskammer 14 vorgeschaltete Kammer 13, die Beschichtungskammer 14, eine nachgeschaltete Kammer 15 und eine Wendestation 16 auf. Die Substrate 17 werden durch die Bereiche 13, 14 und 15 zur Wendestation 16 geführt, in der Wendestation um 180° gedreht und durch die Beschichtungsanlage in entgegengesetzter Richtung zurück geführt. Die Gesamtanlage ist im Wesentlichen spiegelsymmetrisch zur Längsachse der Anlage aufgebaut. Sowohl ein kontinuierlicher als auch ein stationärer Beschichtungsprozess ist denkbar, ebenso ein vertikaler oder horizontaler Transport der Substrate.

Innerhalb der Bereiche 13, 14 und/oder 15 sind heizungen 21 angeordnet. Der Beschichtungsbereich 14 weist an den Übergangsbereichen zu den Bereichen 13 und 15 Trennventile 22 auf. Durch die Trennventile können einzelne Kammerbereiche geflutet werden, beispielsweise für Wartungsarbeiten, während auf ein Fluten der übrigen Bereiche verzichtet werden kann.

Der Beschichtungsbereich 14, der in dem Beispiel einen Kammerabschnitt 2 aufweist, kann wahlweise mit verschiedenen Kathodenanordnungen bestückt werden. Diese sind im unteren Teil der Fig. 2 dargestellt.

Der links dargestellte Zwischenträger 3a trägt Drehkathoden 5a, der in der Mitte dargestellte Zwischenträger 3b Einbau-Flachkathoden 5b. Der rechts gezeigte Träger 3c trägt voneinander getrennte Flachkathoden 5c, wobei jeder Kathode eine eigene Pumpe 18 zugeordnet ist. Der Deckel 4c weist einen Kanal 19 und der Träger 3c Kanäle 20 auf, über die die Evakuierung der Beschichtungskammer erfolgt. Über die Kanäle 20 kann jede Kathode eine ihr zugeordnete Pumpe erhalten. Zwischen den Kathoden sind Trennwände 10 vorgesehen. Durch die Zuordnung einer eigenen Pumpe 18 zu jeder Kathode 5c wird eine individuelle Einstellung des Gasflusses für jede Kathode 5c ermöglicht.

Die Kathoden 5a, 5b, 5c sind jeweils in einem Träger 3a, 3b, 3c zusammengefasst. Sie können für gleiche oder unterschiedliche Prozesse vorgesehen sein. Für unterschiedliche Prozesse können auch verschiedene Module 1 hintereinander angeordnet und in einer Gesamtanlage integriert werden.

Die Deckel 4a, 4b und 4c tragen im Wesentlichen lediglich die Pumpen 18 und dienen zum Abschluss der Beschichtungskammer.

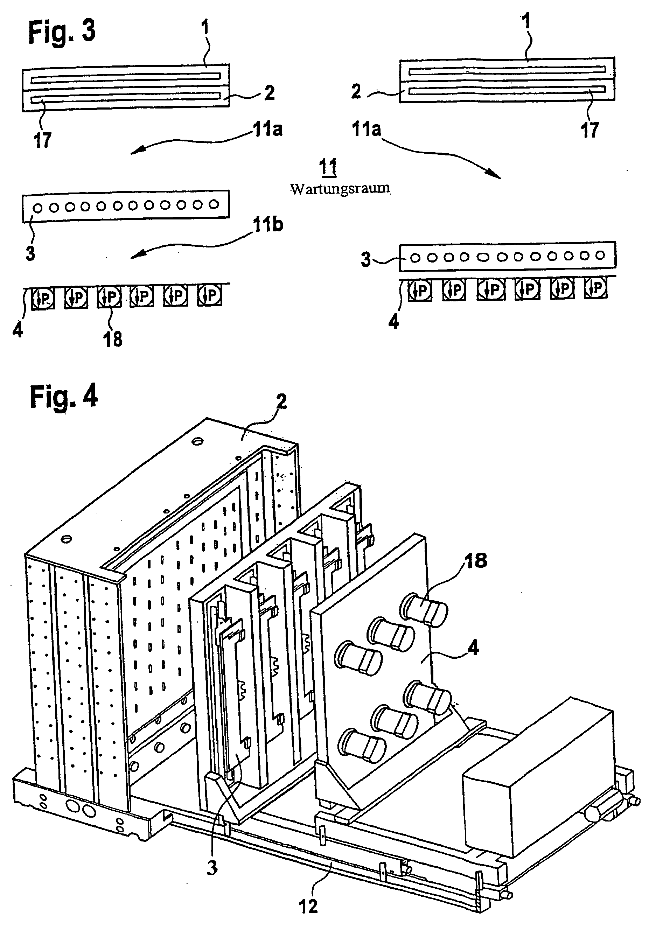

In der Fig. 3 sind zwei Module 1 dargestellt, bei denen der Zwischenträger 3 und der Deckel 4 vom Kammerabschnitt 2 entfernt in zwei unterschiedliche Wartungspositionen gebracht sind.

Die Zwischenträger 3 und die Deckel 4 sind senkrecht zur Transportrichtung der Substrate 17 verfahrbar. Zum Betrieb der Anlage werden die Träger 3 und die Deckel 4 an den Kammerabschnitt 2 herangefahren.

Im links dargestellten Modul 1 sind im vorliegenden Fall zwei Wartungsgänge 11a und 11b zwischen dem Kammerabschnitt 2 und dem Träger 3 bzw. dem Träger 3 und dem Deckel 4 gebildet. Auf diese Weise kann gleichzeitig, vom Wartungsbereich 11b aus, an den im Träger 3 untergebrachten Kathoden und, vom Wartungsbereich 11 a aus, an Komponenten im Kammerinneren gearbeitet werden.

In der rechts dargestellten Position des Trägers 3 und des Deckels 4 ist ein größerer Wartungsbereich 11 a gebildet.

Die Fig. 4 zeigt anschaulich die ,Sandwich"-Bauweise des Moduls 1 mit dem Kammerabschnitt 2, dem Zwischenträger 3, der die Kathoden 5 trägt, sowie dem Deckel 4, an dem die Turbomolekularpumpen 18 angeordnet sind.

Aus der Figur wird zudem die Ausbildung der verfahrbaren Modulkomponenten 3 und 4 als Schlitten, die jeweils auf den Schienen 12 bewegt werden können, deutlich.

## Patentansprüche

1. Anlage zum Beschichten eines Substrats, umfassend eine Beschichtungskammer, wobei die Beschichtungskammer modular aufgebaut ist und ein Modul (1) einen Kammerabschnitt (2), einen ersten Träger (3), der entfernbar im bzw. am Kammerabschnitt (2) angeordnet ist, und einen zweiten Träger (4), der entfernbar am ersten Träger (3) angeordnet ist, aufweist, wobei wenigstens ein Prozesswerkzeug (5) an dem ersten Träger (3) angeordnet ist und der zweite Träger (4) ausgebildet ist, eine seitliche Öffnung des Kammerabschnitts (2) zu verschließen, wobei der erste Träger (3) seitlich entfernbar am Kammerabschnitt (2) und der zweite Träger (4) seitlich entfernbar am ersten Träger (3) angeordnet ist,
**dadurch gekennzeichnet, dass**
der erste Träger (3) zwischen dem Kammerabschnitt (2) und dem zweiten Träger (4) angeordnet ist, wobei die beiden Träger (3, 4) unabhängig voneinander gegeneinander bewegbar ausgebildet sind, wobei der erste Träger (3) und der zweite Träger (4) als aus dem Kammerabschnitt (2) seitlich herausziehbare Wagen oder Schlitten bzw. als vom Kammerabschnitt (2) seitlich wegfahrbare Wagen oder Schlitten ausgebildet sind.

2. Anlage nach Anspruch 1,
**dadurch gekennzeichnet, dass**
die Prozesswerkzeuge (5) in einen gemeinsamen Prozessraum in der Beschichtungskammer angeordnet sind.

3. Anlage nach Anspruch 1,
**dadurch gekennzeichnet, dass**
der erste Träger (3) so ausgebildet ist, dass wenigstens zwei Prozesswerkzeuge (5) oder wenigstens zwei Gruppen von Prozesswerkzeugen (5) in der Beschichtungskammer durch ein am ersten Träger (3) angeordnetes Zwischenelement (10) voneinander getrennt sind.

4. Anlage nach einem der vorhergehenden Ansprüche,
**dadurch gekennzeichnet, dass**
die Anlage eine Pumpeinrichtung zur Erzeugung eines Vakuums in der Beschichtungskammer mit Pumpen (18) aufweist, wobei wenigstens eine der Pumpen (18) am zweiten Träger (4) angeordnet ist.

5. Anlage nach einem der vorhergehenden Ansprüche,
**dadurch gekennzeichnet, dass**
Mittel (12) zur Führung des ersten und/oder des zweiten Trägers (3, 4) beim Herausziehen aus dem Kammerabschnitt (2) bzw. beim Wegfahren vom Kammerabschnitt (2) und/oder beim Hineinschieben in den Kammerabschnitt (2) bzw. beim Heranfahren an den Kammerabschnitt (2) vorgesehen sind.

6. Anlage nach einem der vorhergehenden Ansprüche,
**dadurch gekennzeichnet, dass**
Mittel (12) zur Führung der Träger (3, 4) vorgesehen und so ausgebildet sind, dass der aus dem Kammerabschnitt (2) herausgezogene erste Träger (3) so weit vom Kammerabschnitt (2) entfernt werden kann, dass zwischen dem ersten Träger (3) und dem Kammerabschnitt (2) ein für Personen zugänglicher Bereich (11a) entsteht und/oder Mittel (12) zur Führung der Träger (3, 4) vorgesehen und so ausgebildet sind, dass der vom ersten Träger (3) weggefahrene zweite Träger (4) so weit vom ersten Träger (3) entfernt werden kann, dass zwischen dem .ersten Träger (3) und dem zweiten Träger (4) ein für Personen zugänglicher Bereich (11b) entsteht.

7. Anlage nach einem der vorhergehenden Ansprüche,
**dadurch gekennzeichnet, dass**
die Anlage wenigstens zwei symmetrisch bezüglich der Längsachse der Anlage angeordnete Module (1) aufweist.

8. Modul (1) für eine Anlage zum Beschichten eines Substrats, umfassend wenigstens einen Kammerabschnitt (2), einen ersten Träger (3), der entfernbar im bzw. am Kammerabschnitt (2) angeordnet ist, und einen zweiten Träger (4), der entfernbar am ersten Träger (3) angeordnet ist, wobei wenigstens ein Prozesswerkzeug (5) an dem ersten Träger (3) angeordnet ist und der zweite Träger (4) ausgebildet ist, eine seitliche Öffnung des Kammerabschnitts (2) zu verschließen, wobei der erste Träger (3) seitlich entfernbar am Kammerabschnitt (2) und der zweite Träger (4) seitlich entfernbar am ersten Träger (3) angeordnet ist,
**dadurch gekennzeichnet, dass**
der erste Träger (3) zwischen dem Kammerabschnitt (2) und dem zweiten Träger (4) angeordnet ist, wobei die beiden Träger (3, 4) unabhängig voneinander gegeneinander bewegbar ausgebildet sind, wobei der erste Träger (3) und der zweite Träger (4) als aus dem Kammerabschnitt (2) seitlich herausziehbare Wagen oder Schlitten bzw. als vom Kammerabschnitt (2) seitlich wegfahrbare Wagen oder Schlitten ausgebildet sind.

9. Anlage nach einem der Ansprüche 1 bis 7 und/oder Modul (1) nach Anspruch 8, **dadurch gekennzeichnet, dass** das Prozesswerkzeug (5) wenigstens eine Sputterkathode (5a, 5b, 5c) aufweist.

10. Anlage nach einem der Ansprüche 1 bis 7 oder 9 und/oder Modul (1) nach Anspruch 8 oder 9,
**dadurch gekennzeichnet, dass**
das Prozesswerkzeug (5) wenigstens eine Flachkathode (5b, 5c) und/oder wenigstens eine rotierbare Kathode (5a) aufweist.

11. Anlage nach einem der Ansprüche 1 bis 7, 9 oder 10 und/oder Modul (1) nach einem der Ansprüche 8 bis 10,
**dadurch gekennzeichnet, dass**
mehrere Prozesswerkzeuge (5) benachbart am ersten Träger (3) angeordnet sind.

12. Modul (1) nach Anspruch 11,
**dadurch gekennzeichnet, dass**
der erste Träger (3) so ausgebildet ist, dass wenigstens zwei Prozesswerkzeuge (5) oder wenigstens zwei Gruppen von Prozesswerkzeugen (5) durch ein am ersten Träger (3) angeordnetes Zwischenelement (10) voneinander getrennt sind.

13. Modul (1) nach einem der Ansprüche 8 bis 12,
**dadurch gekennzeichnet, dass**
am zweiten Träger (4) wenigstens eine Pumpe (18) einer Pumpeinrichtung zur Erzeugung eines Vakuums angeordnet ist.

14. Modul (1) nach einem der Ansprüche 8 bis 13,
**dadurch gekennzeichnet, dass**
das Modul (1) so ausgebildet ist, dass der erste und/oder der zweite Träger (3, 4) durch Mittel (12) zur Führung des ersten und/oder des zweiten Trägers (3, 4) beim Herausziehen aus dem Kammerabschnitt (2) bzw. beim Wegfahren vom Kammerabschnitt (2) und/oder beim Hineinschieben in den Kammerabschnitt (2) bzw. beim Heranfahren an den Kammerabschnitt (2) geführt werden können.

15. Modul (1) nach einem der Ansprüche 8 bis 14,
**dadurch gekennzeichnet, dass**
der erste Träger (3) so weit vom Kammerabschnitt (2) entfernbar ist, dass zwischen dem ersten Träger (3) und dem Kammerabschnitt (2) ein für Personen zugänglicher Bereich (11 a) entsteht und/oder der zweite Träger (4) so weit vom ersten Träger (3) entfernbar ist, zwischen dem ersten Träger (3) und dem zweiten Träger (4) ein für Personen zugänglicher Bereich (11b) entsteht.

16. Anlage nach einem der Ansprüche 1 bis 7, 9, 10 oder 11 und/oder Modul (1) nach einem der vorhergehenden Ansprüche 8 bis 16,
**dadurch gekennzeichnet, dass**
der Kammerabschnitt (2) eine im Wesentlichen vertikal ausgerichtete Durchführungsöffnung (7) zur Durchführung des zu beschichtenden Substrats durch den Kammerabschnitt (2) aufweist und/oder die Prozesswerkzeuge (5) am ersten Träger (3) im Wesentlichen vertikal angeordnet sind.

## Claims

1. Machine for coating a substrate, comprising a coating chamber, wherein the coating chamber is modular with one module (1) having a chamber section (2), a first support (3) that is arranged removable in or at the chamber section (2) and a second carrier (4) that is arranged removably at the first support (3), wherein at least one process tool (5) is arranged at the first support (3) and the second support (4) is configured such that it locks a lateral opening of the chamber section (2), wherein the first support (3) can be laterally removed from the chamber section (2) and the second support (4) can be laterally removed from the first support (3),
**characterized in that**
the first support (3) is arranged between the chamber section (2) and the second support (4) wherein the two supports (3, 4) are configured such that they can be moved against each other and independent from each other, with the first support (3) and the second support (4) being formed as cars or carriages that can be laterally retracted from the chamber section (2) or as cars or carriages that can be laterally traversed away from the chamber section (2).

2. Machine according to claim 1,
**characterized in that**
the process tools (5) are arranged in a joint process room in the coating chamber.

3. Machine according to claim 1
**characterized in that**
the first support (3) is configured such that at least two process tools (5) or at least two groups of process tools (5) are separated from one another by an interim element (10) which is arranged at the first support (3).

4. Machine according to one of the preceding claims,
**characterized in that**
the machine has a pump device for generating a vacuum in the coating chamber with pumps (18), wherein at least one of the pumps (18) is arranged at the second support (4).

5. Machine according to one of the preceding claims
**characterized in that**
means (12) are provided for guiding the first and/or the second support (3, 4) as it is retracted from the chamber section (2) or traversed away from the chamber section (2) and/or inserted into the chamber section (2) or traversed up to the chamber section (2).

6. Machine according to one of the preceding claims,
**characterized in that**
means (12) are provided for guiding the supports (3, 4) and are formed such that the first support (3) retracted from the chamber section (2) can be removed so far from the chamber section (2) that an area (11a) accessible to persons is created between the first support (3) and the chamber section (2) and/or means (12) are provided for guiding the supports (3, 4) which are formed such that the second support (4) traversed away from the first support (3) can be removed so far from the first support (3) that an area (11b) accessible to persons is created between the first support (3) and the second support (4).

7. Machine according to one of the preceding claims,
**characterized in that**
the machine features at least two modules (1) which are arranged symmetrically with respect to the longitudinal axis of the machine.

8. Module (1) for a machine for coating a substrate, comprising at least one chamber section (2), a first support (3) that is arranged removably in or at the chamber section (2), and a second support (4) that is arranged removably at the first support (3), wherein at least one process tool (5) is arranged at the first support (3) and the second support (4) is configured such that it locks a lateral opening of the chamber section (2), wherein the first support (3) can be laterally removed from the chamber section (2) and the second support (4) can be laterally removed from the first support (3),
**characterized in that**
the first support (3) is arranged between the chamber section (2) and the second support (4) wherein the two supports (3, 4) are configured such that they can be moved against each other and independent from each other, with the first support (3) and the second support (4) being formed as cars or carriages that can be laterally retracted from the chamber section (2) or as cars or carriages that can be laterally traversed away from the chamber section (2).

9. Machine according to one of the claims 1 to 7 and/or module (1) according to claim 8, **characterized in that** the process tool (5) features at least one sputter cathode (5a, 5b, 5c).

10. Machine according to one of the claims 1 to 7 or 9 and/or module (1) according to claim 8 or 9,
**characterized in that**
the process tool (5) features at least one flat cathode (5b, 5c) and/or at least one rotatable cathode (5a).

11. Machine according to one of the claims 1 to 7, 9 or 10 and/or module (1) according to one of the claims 8 to 10,
**characterized in that**
several process tools (5) are arranged beside each other at the first support (3).

12. Module (1) according to claim 11,
**characterized in that**
the first support (3) is configured such that at least two process tools (5) or at least two groups of process tools (5) are separated from one another by an interim element (10) which is arranged at the first support (3).

13. Module (1) according to one of the claims 8 to 12,
**characterized in that**
at least one pump (18) of a pump device is arranged at the second support (4) for generating a vacuum.

14. Module (1) according to one of the claims 8 to 13,
**characterized in that**
the module (1) is configured such that the first and/or the second support (3, 4) can be guided by means (12) for guiding the first and/or second support (3, 4) as it is retracted from the chamber section (2) or traversed away from the chamber section (2) and/or inserted into the chamber section (2) or traversed up to the chamber section (2).

15. Module (1) according to one of the claims 8 to 14,
**characterized in that**
the first support (3) can be removed so far from the chamber section (2) that an area (11a) accessible to persons is created between the first support (3) and the chamber section (2) and/or the second support (4) can be removed so far from the first support (3) that an area (11b) accessible to persons is created between the first support (3) and the second support (4).

16. Machine according to one of the claims 1 to 7, 9, 10 or 11 and/or module (1) according to one of the preceding claims 8 to 16,
**characterized in that**
the chamber section (2) features an essentially vertical passage (7) for transporting the substrate to be coated through the chamber section (2) and or that the process tools (5) are arranged essentially vertically at the first support (3).

## Revendications

1. Installation destinée au revêtement d'un substrat, comprenant une chambre de revêtement, la chambre de revêtement étant structurée de manière modulaire et un module (1) présentant une section de chambre (2), un premier support (3), lequel est disposé de manière amovible dans la section de chambre (2), respectivement au niveau de la section de chambre (2), et un deuxième support (4), lequel est disposé de manière amovible au niveau du premier support (3), au moins un outil de processus (5) étant disposé au niveau du premier support (3) et le deuxième support (4) étant conçu afin de refermer une ouverture latérale de la section de chambre (2), le premier support (3) étant disposé de manière latérale et amovible au niveau de la section de chambre (2) et le deuxième support (4) étant disposé de manière latérale et amovible au niveau du premier support (3),
**caractérisée en ce que**
le premier support (3) est disposé entre la section de chambre (2) et le deuxième support (4), les deux supports (3, 4) étant conçus de manière à pouvoir être déplacés l'un par rapport à l'autre mais indépendamment l'un de l'autre, le premier support (3) et le deuxième support (4) étant conçus comme des navettes ou des chariots pouvant être extraits latéralement en dehors de la section de chambre (2), respectivement comme des navettes ou des chariots pouvant être éloignés latéralement de la section de chambre (2).

2. Installation selon la revendication 1,
**caractérisée en ce que**
les outils de processus (5) sont disposés dans une chambre de processus commune dans la chambre de revêtement.

3. Installation selon la revendication 1,
**caractérisée en ce que**
le premier support (3) est conçu de telle sorte qu'au moins deux outils de processus (5) ou au moins deux groupes d'outils de processus (5) sont séparés les uns des autres dans la chambre de revêtement par un élément intermédiaire (10) disposé au niveau du premier support (3).

4. Installation selon l'une des revendications précédentes,
**caractérisée en ce que**
l'installation présente un système de pompes destiné à la génération d'un vide dans la chambre de revêtement au moyen de pompes (18), au moins l'une des pompes (18) étant disposée au niveau du deuxième support (4).

5. Installation selon l'une des revendications précédentes,
**caractérisée en ce que**
des moyens (12) destinés au guidage du premier et/ou du deuxième support (3, 4) sont prévus lors de l'extraction en dehors de la section de chambre (2), respectivement lors de l'éloignement de la section de chambre (2) et/ou lors de l'introduction par coulissement dans la section de chambre (2), respectivement lors du rapprochement au niveau de la section de chambre (2)

6. Installation selon l'une des revendications précédentes,
**caractérisée en ce que**
des moyens (12) destinés au guidage des supports (3, 4) sont prévus et sont conçus de telle sorte que le premier support (3) extrait en dehors de la section de chambre (2) peut être espacé aussi loin de la section de chambre (2) de manière à ce qu'une zone (11a) accessible pour des personnes apparaisse entre le premier support (3) et la section de chambre (2) et/ou **caractérisée en ce que** des moyens (12) destinés au guidage des supports (3, 4) sont prévus et sont conçus de telle sorte que le deuxième support (4) qui a été éloigné du premier support (3) peut être espacé aussi loin du premier support (3) de manière à ce qu'une zone (11b) accessible pour des personnes apparaisse entre le premier support (3) et le deuxième support (4).

7. Installation selon l'une des revendications précédentes,
**caractérisée en ce que**
l'installation présente au moins deux modules (1) disposés de manière symétrique par rapport à l'axe longitudinal de l'installation.

8. Module (1) pour une installation destinée au revêtement d'un substrat, comprenant au moins une section de chambre (2), un premier support (3), lequel est disposé de manière amovible dans la section de chambre (2), respectivement au niveau de la section de chambre (2), et un deuxième support (4), lequel est disposé de manière amovible au niveau du premier support (3), au moins un outil de processus (5) étant disposé au niveau du premier support (3) et le deuxième support (4) étant conçu afin de refermer une ouverture latérale de la section de chambre (2), le premier support (3) étant disposé de manière latérale et amovible au niveau de la section de chambre (2) et le deuxième support (4) étant disposé de manière latérale et amovible au niveau du premier support (3),
**caractérisé en ce que**
le premier support (3) est disposé entre la section de chambre (2) et le deuxième support (4), les deux supports (3, 4) étant conçus de manière à pouvoir être déplacés l'un par rapport à l'autre mais indépendamment l'un de l'autre, le premier support (3) et le deuxième support (4) étant conçus comme des navettes ou des chariots pouvant être extraits latéralement en dehors de la section de chambre (2), respectivement comme des navettes ou des chariots pouvant être éloignés latéralement de la section de chambre (2).

9. Installation selon l'une des revendications 1 à 7 et/ou module (1) selon la revendication 8,
**caractérisés en ce que**
l'outil de processus (5) présente au moins une cathode de pulvérisation (5a, 5b, 5c).

10. Installation selon l'une des revendications 1 à 7 ou 9 et/ou module (1) selon la revendication 8 ou 9,
**caractérisés en ce que**
l'outil de processus (5) présente au moins une cathode plate (5b, 5c) et/ou au moins une cathode rotative (5a).

11. Installation selon l'une des revendications 1 à 7, 9 ou 10 et/ou module (1) selon l'une des revendications 8 à 10,
**caractérisés en ce que**
plusieurs outils de processus (5) sont disposés de manière adjacente au niveau du premier support (3).

12. Module (1) selon la revendication 11,
**caractérisé en ce que**
le premier support (3) est conçu de telle sorte qu'au moins deux outils de processus (5) ou au moins deux groupes d'outils sont séparés les uns des autres par un élément intermédiaire (10) disposé au niveau du premier support (3).

13. Module (1) selon l'une des revendications 8 à 12,
**caractérisé en ce que**
au moins une pompe (18) d'un système de pompes destiné à la génération d'un vide est disposée au niveau du deuxième support (4).

14. Module (1) selon l'une des revendications 8 à 13,
**caractérisé en ce que**
le module (1) est conçu de telle sorte que le premier et/ou le deuxième support (3, 4) peuvent être guidés par des moyens (12) destinés au guidage du premier et/ou du deuxième support (3, 4) lors de l'extraction en dehors de la section de chambre (2), respectivement lors de l'éloignement de la section de chambre (2) et/ou lors de l'introduction par coulissement dans la section de chambre (2), respectivement lors du rapprochement au niveau de den section de chambre (2).

15. Module (1) selon l'une des revendications 8 à 14,
**caractérisé en ce que**
le premier support (3) peut être espacé aussi loin de la section de chambre (2) de manière à ce qu'une zone (11a) accessible pour des personnes apparaisse entre le premier support (3) et la section de chambre (2) et/ou le deuxième support (4) peut être espacé aussi loin du premier support (3) de manière à ce qu'une zone (11a) accessible pour des personnes apparaisse entre le premier support (3) et le deuxième support (4).

16. Installation selon l'une des revendications 1 à 7, 9, 10 ou 11 et/ou module (1) selon l'une des revendications précédentes 8 à 16,
**caractérisés en ce que**
la section de chambre (2) présente une ouverture de passage (7), alignée pour l'essentiel à la verticale, et destinée à la réalisation du substrat à revêtir par la section de chambre (2) et/ou les outils de processus (5) sont disposés pour l'essentiel à la verticale au niveau du premier support (3).
